# EUROPÄISCHE PATENTANMELDUNG

(11) **EP 4 567 879 A1**
(43) Veröffentlichungstag der Anmeldung: **11.06.2025**
(21) Anmeldenummer: 23214813.0
(22) Anmeldetag: 07.12.2023
(51) Int. Cl.: H01L 23/427, H01L 23/373

(54) **LEISTUNGSMODUL FÜR EINE ELEKTRONISCHE RECHENEINRICHTUNG, ANORDNUNG SOWIE ELEKTRONISCHE RECHENEINRICHTUNG**

(71) Anmelder: Siemens Aktiengesellschaft, 80333 München (DE)
(72) Erfinder: Bigl, Thomas, 91074 Herzogenaurach (DE); Heimann, Matthias, 14469 Potsdam (DE); Hensler, Alexander, 91466 Gerhardshofen (DE); Müller, Bernd, 16259 Falkenberg (DE); Pfeifer, Markus, 90455 Nürnberg (DE); Stencel, Lisa, 10553 Berlin (DE); Strogies, Jörg, 14163 Berlin (DE)
(74) Vertreter: Siemens Patent Attorneys

(57) **Zusammenfassung**

Die Erfindung betrifft ein Leistungsmodul (12) für eine elektronische Recheneinrichtung (16), mit zumindest einem Leistungschip (22), welcher im Betrieb Wärme erzeugt, und mit einer Fügezone (26), auf welcher der Leistungschip (22) mit einer Unterseite (24) des Leistungschips (22) angeordnet ist, wobei das Leistungsmodul (12) zumindest eine erste Dampfkammereinrichtung (36) aufweist, welche an einer weiteren Seite (38) des Leistungschips (22), welche nicht die Unterseite (24) ist, mit einer Wärmeaufnahmeseite (40) der ersten Dampfkammereinrichtung (36) angeordnet ist, wobei eine Wärmeabgabeseite (42) der ersten Dampfkammereinrichtung (36) an der Fügezone (26) angeordnet ist. Ferner betrifft die Erfindung eine Anordnung (10) sowie eine elektronische Recheneinrichtung (16).

## Beschreibung

Die nachfolgende Erfindung betrifft ein Leistungsmodul für eine elektronische Recheneinrichtung, mit zumindest einem Leistungschip, welcher im Betrieb Wärme erzeugt, und mit einer Fügezone, auf welcher der Leistungschip mit einer Unterseite des Leistungschips angeordnet ist. Ferner betrifft die Erfindung eine Anordnung sowie eine elektronische Recheneinrichtung.

Leistungselektronische Module sind zunehmend durch extreme Leistungsdichten gekennzeichnet. Das bedingt die Herausforderung einer effektiven Abfuhr der entstehenden Verlustwärme. Eine wesentliche Schwachstelle in den Aufbauten besteht im Übergang zwischen dem Leistungsmodul und dem zur konvektiven Wärmeabgabe an luftnotwendigen Kühlkörpern. Diese Grenzflächen stellen allgemein einen limitierenden Faktor dar.

Im Stand der Technik wird diesem Problem beispielsweise durch die Berücksichtigung der Limitierung und entsprechende Auslegungen des Gesamtsystems entgegengetreten. Hierbei wird beispielsweise eine Verlustleistungsdichte begrenzt, oder Wärmeübergangsflächen entsprechend groß ausgebildet. Ferner ist die Anbindung der Module über großflächige Löt- beziehungsweise Sinterverbindungen bekannt. Ferner kann der Kühlkörper, insbesondere im sogenannten Interfacebereich, aus thermisch sehr gut leitfähigen Materialien ausgebildet sein. Ferner sind nicht-übergreifende Oberflächen Dampfkammereinrichtungen (Vapour Chambers) zur lateralen Wärmespreizung im Kühlkörper bekannt.

Aufgabe der vorliegenden Erfindung ist es, ein Leistungsmodul, eine Anordnung sowie eine elektronische Recheneinrichtung zu schaffen, mittels welchen ein verbesserter Betrieb eines Leistungschips beziehungsweise ein verbesserter Betrieb der elektronischen Recheneinrichtung realisiert werden kann.

Diese Aufgabe wird durch ein Leistungsmodul, eine Anordnung sowie eine elektronische Recheneinrichtung gemäß den unabhängigen Patentansprüchen gelöst. Vorteilhafte Ausgestaltungsformen sind in den Unteransprüchen angegeben.

Ein Aspekt der Erfindung betrifft ein Leistungsmodul für eine elektronische Recheneinrichtung, mit zumindest einem Leistungschip, welcher im Betrieb Wärme erzeugt, und mit einer Fügezone, auf welcher der Leistungschip mit einer Unterseite des Leistungschips angeordnet ist.

Es ist dabei vorgesehen, dass das Leistungsmodul zumindest eine erste Dampfkammereinrichtung aufweist, welche an einer weiteren Seite des Leistungschips, welche nicht die Unterseite ist, mit einer Wärmeaufnahmeseite der ersten Dampfkammereinrichtung angeordnet ist, wobei eine Wärmeabgabeseite der ersten Dampfkammereinrichtung an der Fügezone angeordnet ist.

Insbesondere kann somit ein verbesserter Wärmetransport vom Leistungschip zur Fügezone und dann beispielsweise an eine Kühlstruktur realisiert werden.

Im Stand der Technik ist beispielsweise lediglich vorgesehen, dass die Unterseite des Leistungschips entsprechend mit einer Kühlstruktur in Verbindung steht. Erfindungsgemäß ist nun vorgesehen, dass zumindest an einer anderen Seite als der Unterseite eine Dampfkammereinrichtung ausgebildet ist, welche mit der Wärmeaufnahmeseite den Leistungschip berührt und somit die Wärme des Leistungschips aufnehmen kann. Mit einer Wärmeabgabeseite ist wiederum die Dampfkammereinrichtung dann mit der Fügezone kontaktiert, welche dann wiederum die Wärme über die Fügezone an beispielsweise eine Kühlstruktur abgeben kann.

Bei der Dampfkammereinrichtung handelt es sich insbesondere um eine Vapour Chamber. Bei der Kühlung mithilfe einer Vapour Chamber handelt es sich insbesondere um eine Technik zur Wärmeverteilung, bei der die Verdampfung und Kondensation von Flüssigkeit zur Kühlung einer elektronischen Komponente genutzt wird. Insbesondere wird vorliegend nun die Dampfkammereinrichtung mit dem Kühlkörper kombiniert, um den Kühlprozess zu unterstützen.

Bei der Dampfkammereinrichtung handelt es somit insbesondere im Grunde um ein flaches Metallgehäuse, das mit einer Dochtstruktur ausgekleidet ist. Die Dampfkammereinrichtung ist dabei beispielsweise mit einer kleinen Menge Flüssigkeit, insbesondere dem Fluid, gefüllt, und vakuumversiegelt. Der niedrige Druck innerhalb der Dampfkammereinrichtung ermöglicht es der Flüssigkeit, bei Temperaturen zu verdampfen, die unter dem normalen Siedepunkt liegen. Wenn die Dampfkammereinrichtung durch eine elektronische Komponente, wie beispielsweise das Leistungsmodul, erhitzt wird, verdampft die Flüssigkeit. Dieser Dampf zirkuliert sodann durch Konvektion und bewegt sich frei durch die Dampfkammereinrichtung. Wenn dies auf eine kühle Oberfläche trifft, insbesondere dem Kühlkörper, kondensiert er und gibt die absorbierte Wärme ab. Die kondensierte Flüssigkeit bewegt sich daraufhin durch das Dochtmaterial und gelangt zurück auf die wärmere Seite. Und dieser Prozess setzt sich dabei fort, solange das elektronische Bauteil, insbesondere das Leistungsmodul, heiß ist. Die Dampfkammereinrichtung ist dabei insbesondere im Wesentlichen rechtwinklig ausgebildet.

Die Dampfkammereinrichtung kann mit der Wärmeaufnahmeseite beispielsweise an dem Leistungschip verklebt sein, beispielsweise mittels Silber, wodurch auch eine elektrische Kontaktierung zwischen dem Leistungschip und der Dampfkammereinrichtung realisiert werden kann.

Insbesondere werden somit zusätzliche Wärmepfade vom Leistungschip, welche insbesondere als Leistungshalbleiter bezeichnet werden, additiv zur einseitigen, unterseitigen Kühlung durch die Einbindung der Seitenflächen realisiert. Somit kann eine effiziente Wärmespreizung und -abfuhr durch die Nutzung der Dampfkammereinrichtung durchgeführt werden. Des Weiteren kann eine verbesserte Wärmeabfuhr in Richtung der Unterseite realisiert werden.

Insbesondere verhindert somit die vorliegende Erfindung, dass beispielsweise auf der Oberseite des Leistungschips beziehungsweise im Wesentlichen in der Nähe der Oberseite des Leistungschips eine weitere Kühlstruktur auszubilden ist. Somit können beispielsweise Packageprobleme des Leistungsmoduls reduziert werden, da die Wärmeabfuhr lediglich über den einen Kühlkörper beziehungsweise die Fügezone zu realisieren ist.

Insbesondere bietet somit die Erfindung eine Kombination der Vorteile der bisherigen einseitigen und beidseitigen Kühlkonzepte. Dadurch kann eine hohe thermische Performance aufgrund multipler Entwärmungspfade bei gleichzeitig einfacher Systemintegration realisiert werden. Der Einsatz der Dampfkammereinrichtung ermöglicht zudem eine wesentlich effizientere Wärmespreizung und somit eine homogenere Wärmeverteilung und eine schnellere Wärmeabfuhr im Gegensatz zu passiven Materialien.

Erfindungsgemäß ist hier nun vorgeschlagen, dass die Konzepte vereint werden insbesondere eine wird eine semi-doppelseitige Kühlung unter Nutzung von ultradünnen Dampfkammereinrichtungen vereint.

Gemäß einer vorteilhaften Ausgestaltungsform ist der Leistungschip im Wesentlichen quaderförmig ausgebildet und die erste Dampfkammereinrichtung ist an einer Seitenfläche des Leistungschips angeordnet. Insbesondere weist somit der Leistungschip zumindest sechs Seiten auf. Mit der Unterseite ist wiederum der Leistungschip insbesondere mit der Fügezone kontaktiert. Die erste Dampfkammereinrichtung ist dann an einer Seitenfläche, welche im Wesentlichen rechtwinklig zur Unterseite ausgebildet ist, angeordnet. Somit kann die Seitenfläche des Leistungschips ebenfalls als Wärmeaufnahmeseite genutzt werden, wodurch eine verbesserte Wärmeabfuhr des Leistungschips, insbesondere im Betrieb, realisiert werden kann. Dies erhöht insbesondere die Leistung des Leistungschips. Alternativ oder ergänzend kann auch eine geringere Kühlstruktur verwendet werden kann.

Ferner hat es sich als vorteilhaft erwiesen, wenn das Leistungsmodul zumindest eine zweite Dampfkammereinrichtung aufweist, welche gegenüberliegend von der ersten Dampfkammereinrichtung an dem Leistungschip angeordnet ist. Beispielsweise kann dann die zweite Dampfkammereinrichtung ebenfalls an einer Seitenfläche des quaderförmigen Leistungschips angeordnet sein. Somit ist eine weitere Wärmeabfuhr über eine weitere Seite des Leistungschips ermöglicht, wodurch eine verbesserte Kühlung des Leistungschips, insbesondere im Betrieb, realisiert werden kann.

Ferner hat es sich als vorteilhaft erwiesen, wenn das Leistungsmodul zumindest eine dritte Dampfkammereinrichtung aufweist, welche im Wesentlichen rechtwinklig zur ersten Dampfkammereinrichtung am Leistungschip angeordnet ist. Beispielsweise kann dann die dritte Dampfkammereinrichtung an einer weiteren Seite des quaderförmigen Leistungschips angeordnet sein. Somit kann ein nochmals weiterer Wärmepfad geschaffen werden, um verbessert die Wärme von dem Leistungschip abzuführen.

Eine weitere vorteilhafte Ausgestaltungsform sieht vor, dass das Leistungsmodul zumindest eine vierte Dampfkammereinrichtung aufweist, welche gegenüberliegend von der dritten Dampfkammereinrichtung an dem Leistungschip angeordnet ist. Somit können insbesondere an allen vier Seiten des quaderförmigen Leistungschips entsprechende Dampfkammereinrichtungen angeordnet werden, so dass hierbei vorteilhaft eine Wärmeabfuhr realisiert werden kann.

Insbesondere sind an der Oberseite des Leistungschips dann wiederum entsprechende elektronische Bauteile ausgebildet sowie eine Anbindung der elektronischen Bauteile an beispielsweise eine Leiterplatte. Die elektronischen Bauteile können beispielsweise als Gate-Driver und/oder Source-Driver ausgebildet sein.

Die erste Dampfkammereinrichtung, die zweite Dampfkammereinrichtung, die dritte Dampfkammereinrichtung und die vierte Dampfkammereinrichtung können dabei als separate Dampfkammereinrichtungen ausgebildet sein. Bevorzugt sind diese jedoch als gemeinsame beziehungsweise verbundene, und somit eine einzige Dampfkammereinrichtung ausgebildet und beispielsweise rahmenförmig um den Leistungschip angeordnet.

Ferner hat es sich als vorteilhaft erwiesen, wenn das Leistungsmodul zumindest eine fünfte Dampfkammereinrichtung aufweist, welche an einer der Unterseite gegenüberliegenden Oberseite des Leistungschips angeordnet ist. Insbesondere ist die fünfte Dampfkammereinrichtung dann zwischen entsprechenden elektronischen Bauteilen des Leistungschips und einer Leiterplatte angeordnet. Somit kann auch direkt von den elektronischen Bauteilen die Wärme über die fünfte Dampfkammereinrichtung abgeführt werden.

Eine weitere vorteilhafte Ausgestaltungsform sieht vor, dass eine jeweilige Dampfkammereinrichtung räumlich voneinander getrennt zu einer anderen Dampfkammereinrichtung ausgebildet ist. Somit können entsprechende Wärmeüberträge zwischen den jeweiligen Dampfkammereinrichtungen verhindert werden.

Gemäß einer weiteren vorteilhaften Ausgestaltungsform ist eine jeweilige Dampfkammereinrichtung elektrisch voneinander getrennt zu einer anderen Dampfkammereinrichtung ausgebildet.

Insbesondere sollten beispielsweise die Dampfkammereinrichtungen mit entsprechenden elektronischen Bauteilen und somit mit elektrischen Potentialen kontaktiert sein, so ist eine entsprechende elektrische Trennung der Dampfkammereinrichtung von entscheidender Bedeutung, so dass es beispielsweise zu keinem Kurzschluss kommen kann.

Eine weitere vorteilhafte Ausgestaltungsform sieht vor, dass die Fügezone auf einer metallischen Komponente angeordnet ist. Somit kann beispielsweise die Fügezone eine entsprechend Wärmeabfuhr an die metallische Komponente durchführen. Die metallische Komponente weist insbesondere einen hohen Wärmeleitkoeffizienten auf, so dass eine verbesserte Wärmeabfuhr realisiert werden kann.

Eine weitere vorteilhafte Ausgestaltungsform sieht vor, dass die metallische Komponente aus Kupfer ausgebildet ist. Insbesondere Kupfer hat sich bereits als metallische Komponente mit einem hohen Wärmeleitkoeffizienten herausgestellt. Somit kann auf einfache Art und Weise eine Wärmeabfuhr von dem Leistungschip realisiert werden.

Ebenfalls vorteilhaft ist, wenn die metallische Komponente auf einer Isolationsschicht angeordnet ist. Somit kann insbesondere eine elektrische Trennung zwischen der metallischen Komponente und beispielsweise einem darunterliegenden Kühlkörper durchgeführt werden. Somit können entsprechende Kurzschlüsse innerhalb des Leistungsmoduls verhindert werden.

Dabei hat es sich weiterhin als vorteilhaft erwiesen, wenn die Isolationsschicht aus einer Keramik ausgebildet ist. Insbesondere die Keramik hat einen hohen Wärmeleitkoeffizienten und gleichzeitig eine elektrische Isolation. Somit kann mittels einer einzigen Isolationsschicht ein zuverlässiger Wärmetransport von der metallischen Komponente beispielsweise hin zu einer Kühlstruktur erfolgen und gleichzeitig eine elektrische Isolation realisiert werden.

Eine weitere vorteilhafte Ausgestaltungsform sieht vor, dass die Isolationsschicht auf einer weiteren metallischen Komponente angeordnet ist. Beispielsweise kann die weitere metallische Komponente ebenfalls aus Kupfer ausgebildet sein. Die weitere metallische Komponente kann dann beispielsweise wiederum mit einer Seite der metallischen Komponente, welche im Wesentlichen dem Leistungschip abgewandt ist, mit einer Kühlstruktur, beispielsweise einem Kühlkörper aus Aluminium, verbunden sein. Somit kann von der zweiten metallischen Komponente zuverlässig die Wärme an beispielsweise die Kühlstruktur beziehungsweise den Kühlkörper abgegeben werden.

Ein weiterer Aspekt der Erfindung betrifft eine Anordnung mit zumindest einem Kühlkörper und mit einem Leistungsmodul nach dem vorhergehenden Aspekt.

Weiterhin betrifft die Erfindung eine elektronische Recheneinrichtung mit zumindest einer Anordnung nach dem vorhergehenden Aspekt.

Vorteilhafte Ausgestaltungsformen des Leistungsmoduls sind als vorteilhafte Ausgestaltungsformen der Anordnung, sowie der elektronischen Recheneinrichtung anzusehen.

Unter einer Recheneinheit kann insbesondere ein Datenverarbeitungsgerät verstanden werden, das einen Verarbeitungsschaltkreis enthält. Die Recheneinheit kann also insbesondere Daten zur Durchführung von Rechenoperationen verarbeiten. Darunter fallen gegebenenfalls auch Operationen, um indizierte Zugriffe auf eine Datenstruktur, beispielsweise eine Umsetzungstabelle, LUT (englisch: "look-up table"), durchzuführen.

Die Recheneinheit kann insbesondere einen oder mehrere Computer, einen oder mehrere Mikrocontroller und/oder einen oder mehrere integrierte Schaltkreise enthalten, beispielsweise eine oder mehrere anwendungsspezifische integrierte Schaltungen, ASIC (englisch: "application-specific integrated circuit"), eines oder mehrere feldprogrammierbare Gate-Arrays, FPGA, und/oder eines oder mehrere Einchipsysteme, SoC (englisch: "system on a chip"). Die Recheneinheit kann auch einen oder mehrere Prozessoren, beispielsweise einen oder mehrere Mikroprozessoren, eine oder mehrere zentrale Prozessoreinheiten, CPU (englisch: "central processing unit"), eine oder mehrere Grafikprozessoreinheiten, GPU (englisch: "graphics processing unit") und/oder einen oder mehrere Signalprozessoren, insbesondere einen oder mehrere Digitalsignalprozessoren, DSP, enthalten. Die Recheneinheit kann auch einen physischen oder einen virtuellen Verbund von Computern oder sonstigen der genannten Einheiten beinhalten.

In verschiedenen Ausführungsbeispielen beinhaltet die Recheneinheit eine oder mehrere Hardware- und/oder Softwareschnittstellen und/oder eine oder mehrere Speichereinheiten.

Eine Speichereinheit kann als flüchtiger Datenspeicher, beispielsweise als dynamischer Speicher mit wahlfreiem Zugriff, DRAM (englisch: "dynamic random access memory") oder statischer Speicher mit wahlfreiem Zugriff, SR_AM (englisch: "static random access memory"), oder als nicht-flüchtiger Datenspeicher, beispielsweise als Festwertspeicher, ROM (englisch: "read-only memory"), als programmierbarer Festwertspeicher, PROM (englisch: "programmable read-only memory"), als löschbarer programmierbarer Festwertspeicher, EPROM (englisch: "erasable programmable read-only memory"), als elektrisch löschbarer programmierbarer Festwertspeicher, EEPROM (englisch: "electrically erasable programmable read-only memory"), als Flash-Speicher oder Flash-EEPROM, als ferroelektrischer Speicher mit wahlfreiem Zugriff, FRAM (englisch: "ferroelectric random access memory"), als magnetoresistiver Speicher mit wahlfreiem Zugriff, MRAM (englisch: "magnetoresistive random access memory") oder als Phasenänderungsspeicher mit wahlfreiem Zugriff, PCR_AM (englisch: "phase-change random access memory"), ausgestaltet sein.

Unabhängig vom grammatikalischen Geschlecht eines bestimmten Begriffes sind Personen mit männlicher, weiblicher oder anderer Geschlechteridentität mit umfasst.

Weitere Merkmale und Merkmalskombinationen der Erfindung ergeben sich aus den Figuren und deren Beschreibung sowie aus den Ansprüchen. Insbesondere müssen weitere Ausführungsformen der Erfindung nicht unbedingt alle Merkmale eines der Ansprüche enthalten. Weitere Ausführungsformen der Erfindungen können Merkmale oder Merkmalskombinationen aufweisen, die nicht in den Ansprüchen genannt sind.

Dabei zeigen:
- FIG 1: eine schematische Seitenansicht einer Ausführungsform einer Anordnung;
- FIG 2: eine weitere schematische Seitenansicht einer Ausführungsform einer Anordnung; und
- FIG 3: eine schematische Draufsicht auf eine Ausführungsform eines Leistungsmoduls.

In den Figuren sind gleiche oder funktionsgleiche Elemente mit den gleichen Bezugszeichen versehen.

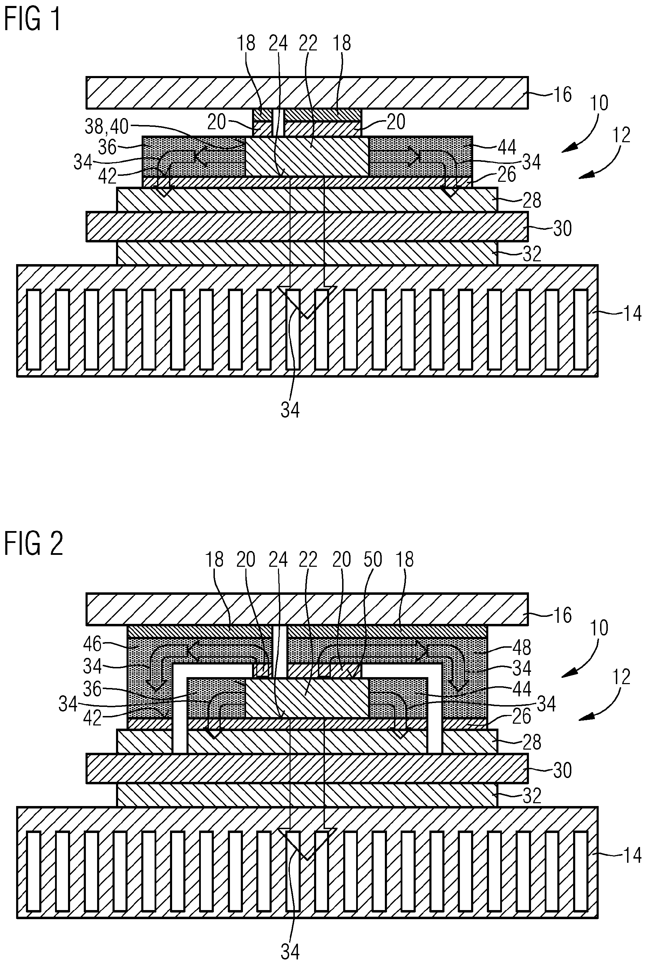

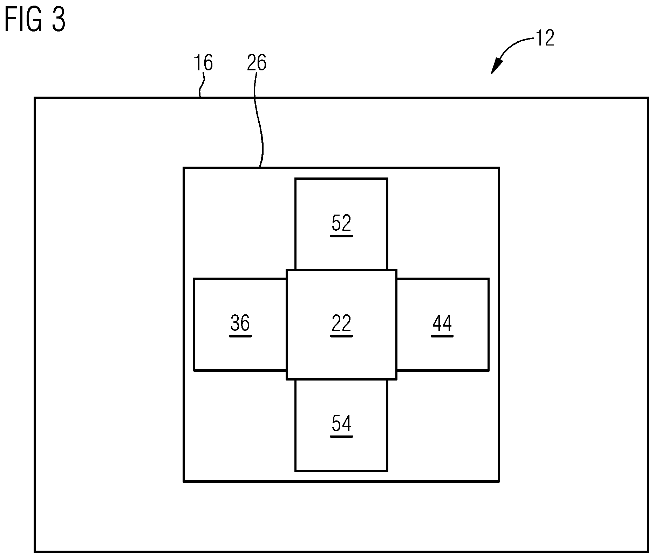

FIG 1 zeigt eine schematische Seitenansicht einer Ausführungsform einer Anordnung 10 mit einem Leistungsmodul 12 sowie mit einem Kühlkörper 14. Die Anordnung 10 ist insbesondere für eine elektronische Recheneinrichtung 16 (FIG 3) ausgebildet.

Der Kühlkörper 14 ist im Wesentlichen mit Kühlrippen versehen, und beispielsweise aus Aluminium ausgebildet.

Das Leistungsmodul 12 weist im vorliegenden Ausführungsbeispiel eine Leiterplatte 16, elektrische Anbindungen 18, welche zur Leiterplatte 16 geführt sind, sowie elektrische Anbindungen 20, beispielsweise zu Gate und Source, des Leistungschips 22 auf. Der Leistungschip 22 ist mit einer Unterseite 24 mit einer Fügezone 26 ausgebildet.

Unterhalb der Fügezone 26 befindet sich eine erste metallische Komponente 28, welche beispielsweise aus Kupfer ausgebildet ist. Ferner ist eine Isolationsschicht 30 gezeigt, welche beispielsweise aus einer Keramik ausgebildet ist. Ferner ist eine weitere metallische Komponente 32 gezeigt, welche mit der Isolationsschicht 30 in Berührung steht. Die weitere metallische Komponente 32 ist ferner mit dem Kühlkörper 14 in Verbindung gebracht. Ferner ist über entsprechende Pfeile 34 eine Wärmeabfuhr vom Leistungschip 22 hin zum Kühlkörper 14 gezeigt.

Insbesondere zeigt somit die FIG 1 das Leistungsmodul 12 für die elektronische Recheneinrichtung 16 mit zumindest dem Leistungschip 22, welcher im Betrieb Wärme erzeugt, und mit der Fügezöne 26, auf welcher der Leistungschip 22 mit einer Unterseite 24 angeordnet ist.

Es ist dabei vorgesehen, dass das Leistungsmodul 12 zumindest eine erste Dampfkammereinrichtung 36 aufweist, welche an einer weiteren Seite 38 des Leistungschips 22, welche nicht die Unterseite 24 ist, mit einer Wärmeaufnahmeseite 40 der ersten Dampfkammereinrichtung 34 angeordnet ist, wobei eine Wärmeabgabeseite 42 der ersten Dampfkammereinrichtung 34 an der Fügezone 26 angeordnet ist.

Wie bereits der FIG 1 zu entnehmen, ist der Leistungschip 22 im Wesentlichen quaderförmig ausgebildet und die erste Dampfkammereinrichtung 34 ist an einer Seitenfläche des Leistungschips 22 angeordnet.

Die FIG 1 zeigt ferner, dass das Leistungsmodul 22 zumindest eine zweite Dampfkammereinrichtung 44 aufweist, welche gegenüberliegend von der ersten Dampfkammereinrichtung 34 an dem Leistungschip 22 angeordnet ist.

Insbesondere zeigt somit die FIG 1, dass zusätzliche Wärmepfade vom Leistungschip 22, welcher insbesondere als Leistungshalbleiter ausgebildet ist, additiv zur einseitigen, unterseitigen Kühlung durch die Anbringung der Seitenflächen mittels der Dampfkammereinrichtungen 34, 44 gebildet werden. Dadurch kann eine effiziente Wärmespreizung und Wärmeabfuhr durch die Nutzung der Dampfkammereinrichtungen 34, 44 realisiert werden. Des Weiteren kann eine Realisierung der Wärmeabfuhr in Richtung zur Unterseite 24, insbesondere in Richtung zum Kühlkörper 14 realisiert werden.

FIG 2 zeigt eine weitere schematische Seitenansicht einer Ausführungsform einer Anordnung 10. In der FIG 2 ist insbesondere gezeigt, dass weitere Dampfkammereinrichtungen 46, 48 vorgesehen sind, welche beispielsweise an einer Oberseite 50 des Leistungschips 22 angeordnet sind. Insbesondere können diese beispielsweise die elektrischen Anbindungen 20 des Leistungschips 22 berühren. Ferner ist gezeigt, dass diese ebenfalls über die Fügezone 26 entsprechend kontaktiert sind und somit eine Wärmeabfuhr auch über die Fügezone 26 erfolgen kann. Des Weiteren ist gezeigt, dass die weiteren Dampfkammereinrichtungen 46, 48 räumlich und elektrisch beispielsweise von der ersten Dampfkammereinrichtung 34 und der zweiten Dampfkammereinrichtung 44 getrennt sind.

Somit kann insbesondere ein zusätzlicher Wärmepfad durch die Anbindung der Oberseite 50 des Leistungschips 22 unter Nutzung der elektrischen Kontakte und effiziente Wärmeabfuhr unter Nutzung der Dampfkammereinrichtungen 46, 48 in Richtung zur Unterseite 24 realisiert werden. Des Weiteren kann eine Trennung der elektrischen Potentiale durch multiple Anschlusselemente, zum Beispiel eine separate Anbindung von Gate und Source, der mechanische Verbund mit beispielsweise Pre-Molded-Leadframes oder durch elektrisch getrennte Lötflächen, auf den Modulen realisiert werden. Dadurch kann eine Kombination von seitlichen und oberseitigen Entwärmungspfaden durch räumlich getrennte Anordnung der elektrischen Isolation mehrerer Dampfkammereinrichtungen 36, 44, 46, 48 realisiert werden.

Dabei zeigt die FIG 2 insbesondere ein Package mit den entsprechenden inneren Dampfkammereinrichtungen 36, 44 zur lateralen Kühlung der Seitenflächen. Zusätzlich sind zwei äußere Dampfkammereinrichtungen 46, 48 gezeigt, um entstehende Verlustwärme auch von der Chipoberseite abzugreifen, radial nach außen zu spreizen und in den äußeren Randbereichen des Leistungsmoduls 12 nach unten über das keramische Substrat in Richtung Kühlkörper 14 abzuführen. Die äußeren wärmerückführenden Dampfkammereinrichtungen 46, 48 müssen aufgrund unterschiedlicher elektrischer Potentiale von Chipober- und -unterseite sowohl räumlich als auch elektrisch getrennt werden. Bei maximaler Ausnutzung der Chipoberseite müssen zudem jeweils separierte Dampfkammereinrichtungen 46, 48 zur Anbindung der Gate- und Sourcepads des Leistungshalbleiters vorgesehen werden. Für die jeweilige elektrische Potentialtrennung ist in der FIG 2 die Metallisierungsschicht des Leiterplattensubstrats sowie des keramischen Substrats entsprechend profiliert. Der mechanische Verbund der einzelnen Dampfkammereinrichtungen 36, 44, 46, 48 kann für eine möglichst einfache Integration zum Beispiel in Form eines Pre-Molded-Packages sichergestellt werden.

FIG 3 zeigt eine schematische Draufsicht auf eine Ausführungsform der elektronischen Recheneinrichtung 16. Vorliegend ist insbesondere gezeigt, dass an den jeweiligen Seitenflächen des Leistungschips 22 jeweilige Dampfkammereinrichtungen 36, 44, 52, 54 ausgebildet sind. Im vorliegenden Ausführungsbeispiel ist insbesondere gezeigt, dass der quaderförmige Leistungschip 22 somit an jeglichen Seitenflächen des Leistungschips 22 eine jeweilige Dampfkammereinrichtung 36, 44, 52, 54 aufweist. Insbesondere zeigt die FIG 3, dass an einer dritten Seite des Leistungschips 22 eine dritte Dampfkammereinrichtung 52 ausgebildet ist und an einer gegenüberliegenden vierten Seite des Leistungschips 22 eine vierte Dampfkammereinrichtung 54 ausgebildet ist, welche insbesondere mit der Fügezone 26 in Kontakt steht und somit die Wärme auch an diese abgeben kann.

Die Fig. 3 zeigt insbesondere, dass die erste Dampfkammereinrichtung 36, die zweite Dampfkammereinrichtung 44, die dritte Dampfkammereinrichtung 52 und die vierte Dampfkammereinrichtung 54 als separate Dampfkammereinrichtungen 36, 44, 52, 54 ausgebildet sein können. Bevorzugt sind diese jedoch als gemeinsame beziehungsweise verbundene, und somit eine einzige Dampfkammereinrichtung 36, 44, 52, 54 ausgebildet und beispielsweise rahmenförmig um den Leistungschip 22 angeordnet.

### Bezugszeichenliste

- 10: Anordnung
- 12: Leistungsmodul
- 14: Kühlkörper
- 16: Leiterplatte
- 18: Kontaktierung
- 20: elektrische Anbindung
- 22: Leistungschip
- 24: Unterseite
- 26: Füge Zone
- 28: metallische Komponente
- 30: Isolationsschicht
- 32: weitere metallische Komponente
- 34: Wärmeabfuhr
- 36: erste Dampfkammereinrichtung
- 38: Seite
- 40: Wärmeaufnahmeseite
- 42: Wärmeabgabeseite
- 44: zweite Dampfkammereinrichtung
- 46: weitere Dampfkammereinrichtung
- 48: weitere Dampfkammereinrichtung
- 50: Oberseite
- 52: dritte Dampfkammereinrichtung
- 54: vierte Dampfkammereinrichtung

## Patentansprüche

1. Leistungsmodul (12) für eine elektronische Recheneinrichtung (16), mit zumindest einem Leistungschip (22), welcher im Betrieb Wärme erzeugt, und mit einer Fügezone (26), auf welcher der Leistungschip (22) mit einer Unterseite (24) des Leistungschips (22) angeordnet ist,
**dadurch gekennzeichnet, dass**
das Leistungsmodul (12) zumindest eine erste Dampfkammereinrichtung (36) aufweist, welche an einer weiteren Seite (38) des Leistungschips (22), welche nicht die Unterseite (24) ist, mit einer Wärmeaufnahmeseite (40) der ersten Dampfkammereinrichtung (36) angeordnet ist, wobei eine Wärmeabgabeseite (42) der ersten Dampfkammereinrichtung (36) an der Fügezone (26) angeordnet ist.

2. Leistungsmodul (12) nach Anspruch 1, **dadurch gekennzeichnet, dass**
der Leistungschip (22) im Wesentlichen quaderförmig ausgebildet ist und die erste Dampfkammereinrichtung (36) an einer Seitenfläche des Leistungschips (22) angeordnet ist.

3. Leistungsmodul (12) nach Anspruch 1 oder 2, **dadurch gekennzeichnet, dass**
das Leistungsmodul (12) zumindest eine zweite Dampfkammereinrichtung (44) aufweist, welche gegenüberliegend von der ersten Dampfkammereinrichtung (36) an dem Leistungschip (22) angeordnet ist.

4. Leistungsmodul (12) nach einem der vorhergehenden Ansprüche, **dadurch gekennzeichnet, dass**
das Leistungsmodul (12) zumindest eine dritte Dampfkammereinrichtung (52) aufweist, welche im Wesentlichen rechtwinklig zur ersten Dampfkammereinrichtung (36) am Leistungschip (22) angeordnet ist.

5. Leistungsmodul (12) nach Anspruch 4, **dadurch gekennzeichnet, dass**
das Leistungsmodul (12) zumindest eine vierte Dampfkammereinrichtung (54) aufweist, welche gegenüberliegend von der dritten Dampfkammereinrichtung (52) an dem Leistungschip (22) angeordnet ist.

6. Leistungsmodul (12) nach einem der vorhergehenden Ansprüche, **dadurch gekennzeichnet, dass**
das Leistungsmodul (12) zumindest eine fünfte Dampfkammereinrichtung (46, 48) aufweist, welche an einer der Unterseite (24) gegenüberliegenden Oberseite (50) des Leistungschips (22) angeordnet ist.

7. Leistungsmodul (12) nach einem der Ansprüche 3 bis 6, **dadurch gekennzeichnet, dass**
eine jeweilige Dampfkammereinrichtung (36, 44, 46, 48, 52, 54) räumlich voneinander getrennt zu einer anderen Dampfkammereinrichtung (36, 44, 46, 48, 52, 54) ausgebildet ist.

8. Leistungsmodul (12) nach einem der Ansprüche 3 bis 7, **dadurch gekennzeichnet, dass**
eine jeweilige Dampfkammereinrichtung (36, 44, 46, 48, 52, 54) elektrisch voneinander getrennt zu einer anderen Dampfkammereinrichtung (36, 44, 46, 48, 52, 54) ausgebildet ist.

9. Leistungsmodul (12) nach einem der vorhergehenden Ansprüche, **dadurch gekennzeichnet, dass**
die Fügezone (26) auf einer metallischen Komponente (28) angeordnet ist.

10. Leistungsmodul (12) nach Anspruch 9, **dadurch gekennzeichnet, dass**
die metallische Komponente (28) aus Kupfer ausgebildet ist.

11. Leistungsmodul (12) nach Anspruch 9 oder 10, **dadurch gekennzeichnet, dass**
die metallische Komponente (28) auf einer Isolationsschicht (30) angeordnet ist.

12. Leistungsmodul (12) nach Anspruch 11, **dadurch gekennzeichnet, dass**
die Isolationsschicht (30) aus einer Keramik ausgebildet ist.

13. Leistungsmodul (12) nach Anspruch 11 oder 12, **dadurch gekennzeichnet, dass**
die Isolationsschicht (30) auf einer weiteren metallischen Komponente (32) angeordnet ist.

14. Anordnung (10) mit zumindest einem Kühlkörper (149 und mit einem Leistungsmodul (12) nach einem der Ansprüche 1 bis 13.

15. Elektronische Recheneinrichtung (16) mit zumindest einer Anordnung (10) nach Anspruch 14.
